# EUROPEAN PATENT SPECIFICATION

(11) **EP 1 591 801 B1**
(45) Date of publication and mention of the grant of the patent: **13.08.2008**
(21) Application number: 04445050.0
(22) Date of filing: 29.04.2004
(51) Int. Cl.: G01S 7/285, G01S 7/282

(54) **Automatic frequency control for a magnetron radar**
Automatische Frequenzregelung für ein Radar mit Magnetron
Commande automatique de fréquence pour un radar à magnétron

(43) Date of publication of application: 02.11.2005
(73) Proprietor: SAAB AB, 581 88 Linköping (SE)
(72) Inventor: Remle, Joachim, 187 35 Täby (SE)
(74) Representative: Falk, Bengt

(56) References cited:
- FR-A- 2 269 719
- FR-A- 2 335 997
- GB-A- 2 052 191
- US-A- 5 107 272
- US-A- 5 151 703
- US-A1- 2003 174 087
- US-B1- 6 177 764
- RAMANAIAH K ET AL: "Control of magnetron frequency using digital AFC" ELECTRO-TECHNOLOGY INDIA, vol. 19, no. 3, 1 September 1975 (1975-09-01), pages 50-52, XP009036549 ISSN: 0013-4643
- PATENT ABSTRACTS OF JAPAN vol. 1997, no. 07, 31 July 1997 (1997-07-31) -& JP 09 072954 A (MITSUBISHI ELECTRIC CORP), 18 March 1997 (1997-03-18)

## Description

Method and device for producing a receiver signal in radar systems

The present invention relates to a method and device for producing a receiver signal that is precise as far as frequency is concerned during a determined listening time in a radar system comprising a magnetron. For this purpose, a local oscillator arrangement is utilized, in which a voltage-controlled oscillator (VCO) is controlled by a control loop or feedback loop.

A local oscillator arrangement is used with a magnetron radar in order to create the said receiver signal. Frequency diversity is created by means of variation in the size of the frequency-determining cavities in the magnetron, which variation is carried out by rotation of the tuning unit. The frequency varies as a sine. Random frequency is created by the distance between each transmission pulse being selected at random. In the case of frequency-hopping radar systems that are used in hop frequency mode, the local oscillator, called here LO, changes the frequency for each transmission pulse. After the end of the listening time and before the next transmission pulse the LO follows the cold frequency using a control system. The signal from a cold-following crystal is used for this. Before the transmission pulse, the voltage-controlled oscillator (VCO) is adjusted by one step that corresponds to the difference between cold (not transmitting) and hot (transmitting) frequency minus the intermediate frequency. During the transmission pulse, the frequency difference between LO and the magnetron is then adjusted to the same value as the intermediate frequency. The signal from the AFC mixer is used for this (AFC = Automatic Frequency Control). During the whole listening time, the LO will then remain in the frequency so that the intermediate frequency does not change too much, a function that is called PTD. (PTD - Post Tuning Drift).

In particular, the invention utilizes measuring of the transmission frequency and setting of the correct frequency by the LO during the listening time. The LO and the magnetron operate at, for example, 8 to 10 GHz or 15 to 18 GHz, but the basic ideas are also applicable for other frequencies. The new method and device are applicable for both fixed-frequency and frequency-hopping radar systems.

The use of analogue control and feedback loops is already known in this specifically stated context. In this connection, reference can be made to the magnetron radar systems available on the market, for example the system provided by Saab Bofors Dynamics AB.

The present invention is based on the fact that, in general, digital control loops can generate quick and reliable functions in radar systems. In this connection, reference can be made to US 6 177 764 which proposes the utilization of sampling and locking loops that compare detected peak values with a threshold value so that a required level is maintained at maximum current. GB 2 052 191 proposes addressing of control signals where the receiver comprises a ROM the output of which controls the magnetron in order to keep the frequency difference constant. FR 2 335 997 describes a phase locking loop for a local oscillator in radar equipment and an arrangement for comparing the phases of a magnetron's output with the receiving oscillator. JP 9 072 954 proposes a radar receiver that uses a magnetron. The receiver operates with a digital synthesizer that is connected to phase detectors.

Document US 5 151 703 discloses a Radar comprising a magnetron and corresponding to the preamble of claims 1 and 5.

In connection with the specifically stated context, the local oscillator must operate with quick and electrical tuning. With the utilization of the voltage-controlled oscillator (VCO = Voltage-Controlled Oscillator) in the current solution, it is necessary to utilize parameters in the tuning circuit (the part that determines the frequency) that are difficult to fulfil in a noncritical quickly-operating local oscillator. The parameters that are difficult to handle with the design of VCO include obtaining the linearity of the tuning curve and PTD. It is also important to be able to make the local oscillator operate non-critically at all temperatures and frequencies that may occur. The present invention intends to solve this problem amongst other things, and thus aims to make it possible to set lower requirements of oscillator function and of components in this and still produce the required precise receiver signal.

The principal characteristic of a method according to the invention is that during the magnetron's outgoing pulse or listening time, a number of components and functions are activated that are arranged in a specific way. Firstly, a mixer is activated that mixes (multiplies) the magnetron's outgoing frequency by the outgoing frequency of the voltage-controlled oscillator, so that a difference frequency is created in analogue form. Thereafter, functions are activated for filtering, digitizing and sampling to generate an estimated difference frequency in digital form between the said outgoing frequencies. A comparison is activated between the estimated frequency in digital form and a required difference frequency. The result of the comparison is utilized for correction of a frequency that, before initiation of the magnetron's outgoing pulse, is set approximately by means of the local oscillator arrangement.

Thereafter production is initiated, by means of a translation table contained in memory, of a divisor, preferably a digital quantity, which is related to the value of the current frequency of the local oscillator arrangement. Finally, transmission is initiated of the divisor or the digital quantity or the information about this to the control loop mentioned in the introduction, which can thereby fine-tune the oscillator to provide the precise receiver signal.

In further developments of the new method, the divisor or the information about this is sent to a frequency divider comprised in the control loop, in which the oscillator's current frequency is divided by the divisor. The divided frequency can thereafter be sent to a phase detector similarly comprised in the control loop. An error signal is initiated which corrects the frequency from the local oscillator until the error at the output of the phase detector is zero or assumes a small value, whereby the oscillator is adjusted and can provide the precise receiver signal on the receiver frequency. The said embodiments also include the estimated difference frequency in digital form being able to be transmitted to a first digital adder together with the required frequency difference between the local oscillator arrangement and the magnetron's transmission pulse, and a difference being initiated between the estimated frequency and the required frequency. A second digital adder is utilized to add either the value zero or the frequency error which corrects the outgoing frequency from the local oscillator arrangement to the required value. In addition, a crystal for reference frequency can be connected to the phase detector.

The principal characteristic of the new device is that a first means is arranged to receive and mix the magnetron's outgoing frequency and create a difference frequency in analogue form. In addition, the device comprises a second means arranged after the first means, which second means has functions for filtering, digitizing and sampling in order to generate an estimated difference frequency in digital form between the outgoing frequencies mentioned in the above. In addition, a third means is arranged to receive and compare the estimated frequency in digital form with a required difference frequency, the result of the comparison being used in a fourth means for correction of a frequency initiated by an approximate-setting function, which frequency, before initiation of the magnetron's outgoing pulse, is approximately set by means of the local oscillator arrangement. At least one memory function is arranged with a translation table with divisors or digital quantities which are set in relation to various possible output frequencies of the local oscillator arrangement. A relevant divisor or relevant quantity can be determined by or derived from the local oscillator arrangement's current output frequency and, in addition, the control loop is arranged to receive the current divisor or the digital quantity or the information about this and fine-tune the voltage-controlled oscillator so that this can provide the precise receiver signal.

In one embodiment, the control loop comprises a frequency divider connected to the output of the oscillator and arranged to receive the divisor or the digital quantity or the information about this and to divide the oscillator's current frequency by the divisor. A phase detector comprised in the control loop receives information about the divided frequency and using this can generate error signals which correct the frequency from the local oscillator until the phase error at the phase detector's output is zero or assumes a small value. A first digital adder receives the estimated difference frequency and the required frequency difference between the local oscillator arrangement's outgoing frequency and the magnetron's transmission pulse. The first digital adder generates a difference, called here the frequency error, between the estimated frequency and the required frequency. A second digital adder is arranged to add either zero or the frequency error which corrects the outgoing frequency from the local oscillator arrangement to the required value. The said second means can operate with a low-pass filter, a comparator and a frequency counter. In addition, the arrangement can comprise a change-over switch or change-over function. The change-over switch operates with disconnected and connected positions, the second adder being disconnected until the frequency estimation is ready and being connected when it is to generate frequency errors which correct the oscillator frequency to the required frequency.

Further embodiments are apparent from the following subsidiary claims.

An efficient digitally-operating control system can be achieved with the above characteristics. Prior to the initiation of the magnetron's input pulse, the updating in question is stopped. During the transmission pulse, the frequency difference is thus measured between the voltage-controlled oscillator and the magnetron by means of an A/D conversion function and circuit that can be programmed with digital quantities. Depending upon how much the frequency differs from the intermediate frequency, fine-tuning can be carried out so that the correct intermediate frequency is obtained, for example by setting a digital quantity, whereby the correct frequency is obtained. During the listening time, the frequency of the local oscillator can be controlled efficiently, which means that PTD is not a problem, as the intermediate frequency can be locked to lie within the bandwidth of the filter in question (the receiver filter).

Currently proposed embodiments of the method and device according to the invention will be described below with reference to the attached drawings in which
Figure 1 shows in block diagram form and in outline a local oscillator arrangement for a magnetron,
Figure 2 shows in the form of a diagram an example of the tuning function of the local oscillator in relation to the magnetron's cold and hot frequencies, and
Figure 3 shows in block diagram form the principle for selecting different divisors with different frequencies.

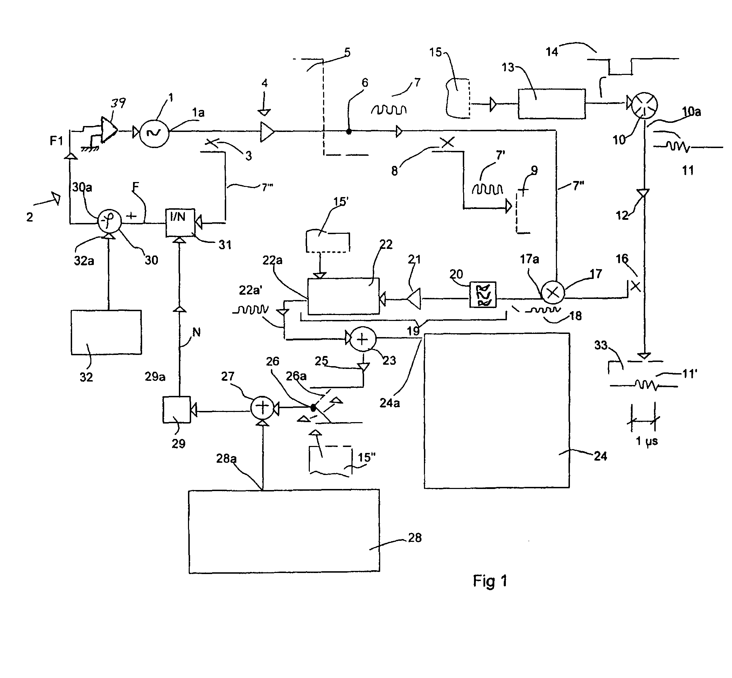

In Figure 1 a voltage-controlled oscillator is represented diagrammatically by 1. The oscillator is controlled by a control loop 2. The control loop detects the outgoing frequency/power from the oscillator by means of a switch 3 that connects part of the power to the control loop. An amplifier 4 is connected at the output of the oscillator, after the switch, which increases the power of the output signal. The local oscillator arrangement in question is indicated symbolically by 5 and the output of the arrangement is symbolized by 6. The signal obtained at the output is shown by 7. The frequency of the signal can lie within the range 8-10 GHz or the range 15-18 GHz. The arrangement works, however, for other frequency ranges. A second switch 8 is arranged at the said output 6 in order to disconnect part of the power at the output 6 to a receiver that is symbolically indicated by 9. The receiver is placed in a known way in the magnetron arrangement. A magnetron, which is a high power oscillator, is symbolized by 10. The magnetron or high power oscillator generates a transmission pulse 11 at the output 12 of the magnetron. The transmission pulse can, for example, lie within the power range approx. 10-100 kW and have a frequency within the range 8-10 GHz or 15-18 GHz. The transmission pulse is transmitted for a period of time, which can typically be 1 µs. A modulator 13 provides the magnetron 10 with a voltage pulse 14 which typically can assume the value -10 kV. The said transmission pulse 11 is initiated by means of the voltage pulse 14. The modulator is controlled from the synchronization system of the radar system in question, which synchronization system has been symbolized by 15 in Figure 1. A third switch 16 is connected to the magnetron's output and disconnects part of the magnetron's outgoing power to a mixer 17 (first means). The mixer is also connected to the output 6 of the oscillator 1. The mixer creates difference frequencies and summation frequencies from the signals coming into the mixer from the local oscillator, from the said amplifier 4, and the magnetron 10. At the output 17a of the mixer, the said difference frequencies and summation frequencies 18 are obtained which can lie within the range 10-100 MHz and > 1 GHz respectively. A second means is represented by 19. The second means comprises in the present case a low-pass filter 20 connected to the output of the mixer, which filter filters out the summation frequency from the mixer 17. A comparator 21 is connected to the output of the low-pass filter which digitizes the signal from the low-pass filter 20 into one or more bits. The second means also comprises a digital circuit which estimates the frequency of the outgoing signal from the comparator 21. The circuit 22 samples the data in question during a part of the duration of the transmission pulse 11, for example 0.5 µs. Thereafter the frequency is estimated in the circuit 22 which can operate with frequency counter function. The output of the circuit 22 is connected to a digital first adder 23. In addition, there is a unit 24 for indicating the required difference frequency, which is the same as the intermediate frequency of the receiver. In the receiver 9 signals from the antenna which have the same frequency as the transmission pulse are thus mixed with the local oscillator signal so that a signal is created at the receiver's intermediate frequency. The intermediate frequency in question in the receiver can be, for example, 50 MHz. The output 24a of the unit 24 is connected to the first digital adder 23. The sampling time of the circuit 22 is controlled from the radar's synchronization system which is symbolized by 15' in the figure. The first digital adder calculates the difference, that is the frequency error 25, between the estimated frequency and the required frequency. Forwarding of the output of the first digital adder is carried out by means of a change-over means 26 that operates in connected and disconnected positions. The change-over switch 26, which is controlled from the radar's synchronization system 15", is in a zero position (0) until the frequency estimation in the first adder 23 has been completed or carried out. After the frequency estimation has been carried out, the change-over switch changes to the position shown by the broken line 26a and the frequency error is sent to a second digital adder 27 which can thus add either zero or the frequency error which corrects the frequency of the local oscillator to the required frequency. In the arrangement, there is also an approximate-setting unit for the local oscillator frequency for the transmission of the transmission pulse 11. At the stage before the transmission pulse, the local oscillator has been set so that it is correct at, for example, 50 MHz, meaning that the signal from the mixer 17 lies within the operational range of the comparator 21 and the frequency counter 22. The output 28a of the approximate-setting unit 28 is connected to the second digital adder. The output of the second digital adder is connected to a memory function or a memory which can consist of a ROM. The memory function can operate with or comprise a translation table between a frequency derived from the local oscillator's output frequency and a divisor N which is to be transmitted via the output 29a of the memory function to the control loop 2 of the oscillator 1. In the said control loop 2 there is a phase/frequency detector 30 which measures the difference in phase/frequency between a reference which is typically in the MHz range. In the control loop there is also a frequency divider 31 which divides the outgoing frequency of the oscillator 1 by a number N which is sent from the memory function 29. The division means that the detector 30 receives a frequency F in the MHz range. The detector thereby creates an error signal F1 which is amplified in an error amplifier 39 in order then to correct the frequency of the oscillator 1 until the phase error at the output 30a of the phase detector is zero or small. The detector 30 is also connected to a crystal oscillator which operates in the MHz range, which frequency thus constitutes a reference frequency. The output 10a of the magnetron is connected to an antenna unit 33 indicated symbolically in Figure 1 and sends to this the part 11' of the signal 11 which was not disconnected. The respective transmission pulses occur according to the above for a duration of, for example, 1 µs.

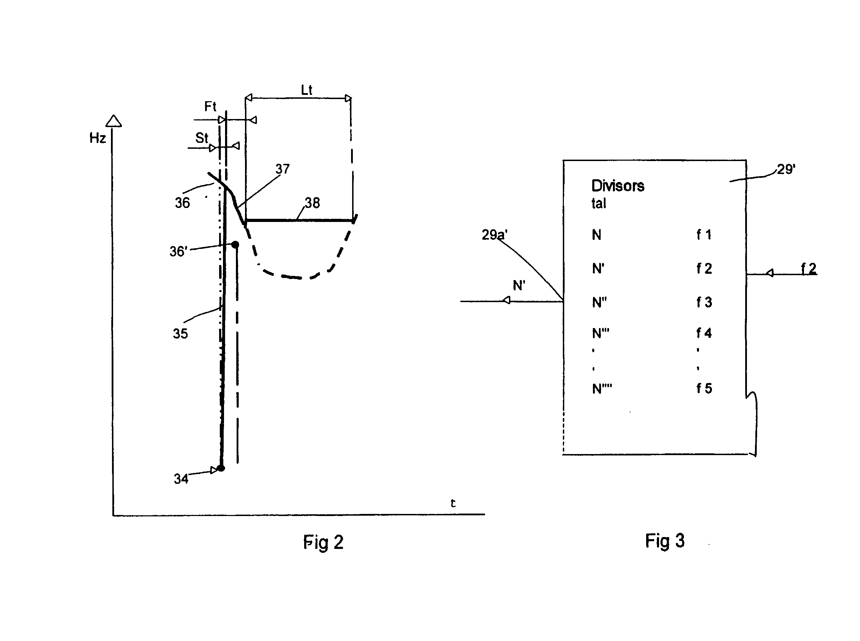

In Figure 2 a typical tuning curve for a local oscillator is shown diagrammatically. The local oscillator assumes an output frequency 34 in the frequency/time diagram. The oscillator operates with a sweep function 35 in order to search for the cold frequency 36 in question. When the cold frequency is encountered, the oscillator follows the cold frequency during a stage 37. After the stage 37, the curve changes to a listening stage 38. The time of the sweep stage has been indicated in Figure 2 by St, the time of the following stage by Ft and the time of the listening stage by Lt. In accordance with the above, the new arrangement operates principally during the said stage 38 and the listening time Lt.

Figure 3 shows in somewhat greater detail the function of the memory function 29' (cf. 29 in Figure 1). A number of divisors N, N' ... N"" are pre-programmed into the memory function unit 29'. In addition, a number of frequencies f1, f2 ... f5 are programmed in, each of which corresponds to one of the said divisors. Depending upon the frequency of the error frequency output from the second digital adder 27 (cf. Figure 1), a relevant divisor is selected. In the present case, this has been illustrated by a frequency f2 being transmitted from the digital adder 27, which according to the translation table means that a divisor N' is to be transmitted to the frequency divider 31.

The incoming signal of the receiver 9 is indicated by 7' and the input signal connected to the mixer 17 is indicated by 7" . The output of the unit 22 is indicated by 22a and the estimated difference frequency is symbolized by 22a'. The reference signal from the crystal 32 has been indicated by 32a. The output of the oscillator 1 is indicated by 1a and the frequency received via the switch 3 to the control loop is indicated by 7"'. The functions and components mentioned above can be constructed in a known way.

The method and the device according to the invention are not limited to the embodiments described above, but can be modified within the framework of the following claims and concept of the invention.

## Claims

1. Method for producing a receiver signal (7') that is precise as far as frequency is concerned during a determined listening time (Lt) in a system comprising a magnetron (10) utilizing a local oscillator arrangement (5), in which a voltage-controlled oscillator (VCO) is controlled by a control loop (2), whereby during the magnetron's outgoing pulse, mixing (multiplying) of the magnetron's outgoing frequency by the outgoing frequency of the voltage-controlled oscillator to create a difference frequency (18) in analogue form is effected by a mixer (17); filtering (20), digitizing (21) and sampling (22) in said order to generate an estimated difference frequency (22a') in digital form between the said outgoing frequencies is effected after said mixing; comparison between the estimated frequency (22a') in digital form and a required difference frequency, the result of the comparison being utilized for correction of a frequency that before initiation of the magnetron's outgoing pulse is set approximately by means of the local oscillator arrangement; production by means of a translation table comprised in a memory (ROM) (29) of a divisor, preferably a digital quantity, which is related to the value of the current output frequency of the local oscillator arrangement; and transmission of the divisor or the digital quantity or information about this to the control loop (2), which can thereby fine-tune the oscillator (1) by means of an error signal to provide the precise receiver signal, **characterized in that** the divisor (N) or the information about this is transmitted to a frequency divider (31) comprised in the control loop, in which the oscillator's current output frequency (7''') is divided by the divisor, **in that** the divided frequency is sent to a phase detector (30) similarly comprised in the control loop, and **in that** said error signal (F1) is initiated which corrects the frequency (7) from the local oscillator until the phase error at the output of the phase detector 30a is zero or assumes a small value.

2. Method according to Claim 1, **characterized in that** the estimated difference frequency in digital form is sent to a first digital adder (23) together with the required frequency difference between the local oscillator arrangement and the magnetron's transmission pulse (11), and **in that** a difference, called here the frequency error (25), between the estimated frequency and the required frequency is initiated.

3. Method according to Claim 2, **characterized in that** in a second digital adder (27) either the value zero or the frequency error is added which corrects the outgoing frequency from the local oscillator arrangement to the required value.

4. Method according to Claim 1, **characterized in that** a reference frequency (32a) is sent to the phase detector.

5. Device for producing a receiver signal (7') that is precise as far as frequency is concerned during a determined listening time in a system comprising a magnetron (10) utilizing a local oscillator arrangement (5), in which a voltage-controlled oscillator (VCO) can be controlled by a control loop (2), whereby a first means (17) is arranged to receive and mix (multiply) the magnetron's outgoing frequency by the outgoing frequency of the oscillator and to create a difference frequency in analogue form; a second means (19) arranged after the first means is arranged with functions for filtering, digitalizing and sampling to generate an estimated difference frequency (22a') in digital form between the said outgoing frequencies; a third means (23) is arranged to receive and compare the estimated frequency in digital form with a required difference frequency, the result of the comparison being utilized in a fourth means (27) for correction of a frequency initiated by an approximate-setting function (28), which frequency, before initiation of the magnetron's outgoing pulse, is set approximately by means of the local oscillator arrangement (5); at least one memory (ROM) is arranged with a translation table with divisors (N), preferably digital quantities, which are set in relation to different possible output frequencies (7) from the local oscillator arrangement; a relevant divisor or digital quantity can be determined among other things using the local oscillator arrangement's current output frequency; and said control loop is arranged to receive the current divisor or the digital quantity or the information about this, and to fine-tune by means of an error signal the oscillator to provide the precise receiver signal, **characterized in that** the control loop comprises a frequency divider (31) connected to the output of the oscillator and arranged to receive the divisor or the digital quantity or the information about this and to divide the oscillator's current frequency (7"') by the divisor (N), and **in that** the control loop (2) comprises a phase detector (30) arranged to receive the divided frequency and, utilizing this, to generate said error signal (F1) which corrects the frequency (7) from the local oscillator until the phase error at the phase detector's output (30a) is zero or assumes a small value.

6. Device according to Claim 5, **characterized in that** a first digital adder (23) is arranged to receive the estimated difference frequency and the required frequency difference between the local oscillator arrangement's outgoing frequency and the magnetron's transmission pulse and to generate a difference, called here the frequency error (25), between the estimated frequency and the required frequency.

7. Device according to Claim 6, **characterized in that** a second digital adder (27) is arranged to add either zero or the frequency error which corrects the outgoing frequency from the local oscillator arrangement to the required value.

8. Device according to Claim 5,6 or 7, **characterized in that** the phase detector (30) is arranged to receive a reference frequency (32a).

9. Device according to any one of Claims 5-8, **characterized in that** the second means (19) comprises a low-pass filter (20) which filters off the summation frequency from a mixer (17) constituting the first means or comprised in the first means.

10. Device according to any one of Claims 5-9, **characterized in that** the second means (19) comprises a comparator (21) which digitizes a signal frequency obtained from a filtering function.

11. Device according to any one of Claims 7-10,
**characterized in that** the second means comprises a digital circuit, called here a frequency counter (22), which estimates the frequency of the signal from the comparator, which digital circuit is arranged to sample data during the magnetron's transmission pulse, for example with a duration of 0.5 µs, and thereafter to estimate the frequency.

12. Device according to Claim 11, **characterized in that** the first digital adder (23) is connected to the outputs of the digital circuit/the frequency counter (22) and a unit (24) which generates the required frequency difference between the oscillator and the magnetron's transmission pulse, and **in that** the first digital adder is connected to the second digital adder via a change-over function (26) with disconnected and connected positions, the second adder being disconnected until the frequency estimation is ready and being connected when it is to generate frequency errors which correct the oscillator frequency to the required frequency.

13. Device according to Claim 11 or 12, **characterized in that** the digital circuit's sampling time and the change-over switch are arranged to be able to be controlled from the system's synchronization function (15', 15'').

14. Device according to Claim 10, **characterized in that** the comparator (21) that digitizes a signal frequency received from the filtering function comprises two output levels.

15. Device according to Claim 10, **characterized in that** the comparator (21) that digitizes a signal frequency received from the filtering function comprises more than two output levels.

16. Device according to any of Claims 10, 14 or 15, **characterized in that** the comparator (21) comprises an A/D converter.

## Patentansprüche

1. Verfahren zur Herstellung eines Empfängersignals (7'), das mit Bezug auf die Frequenz während einer bestimmten Abhörzeit (Lt) präzise ist, in einem System mit einem Magnetron (10), das eine lokale Oszillatoranordnung (5) verwendet, in der ein spannungsgesteuerter Oszillator (VCO) durch eine Steuerschleife (2) gesteuert wird, wodurch während des Ausgangsimpulses des Magnetrons ein Vermischen (Multiplizieren) der Magnetron-Ausgangsfrequenz mit der Ausgangsfrequenz des spannungsgesteuerten Oszillators zum Erzeugen einer Differenzfrequenz (18) in analoger Form, durch einen Mischer (17) bewirkt wird; nach dem Mischen ein Filtern (20), Digitalisieren (21) und Abtasten (22) in der genannten Reihenfolge bewirkt wird, um eine geschätzte DifFerenzfrequenz (22a') in digitaler Form zwischen den Ausgangsfrequenzen zu erzeugen; die gesetzte Frequenz (22a') in digitaler Form und eine erforderliche Differenzfrequenz verglichen werden, wobei das Vergleichsergebnis für die Korrektur einer Frequenz verwendet wird, die vor der Initiation des Ausgangsimpulses des Magnetrons annähernd mittels der lokalen Oszillatoranordnung gesetzt worden ist; Erzeugen eines Divisors, vorzugsweise einer digitalen Größe, der bezogen ist auf den Wert der derzeitigen Ausgangsfrequenz der lokalen Oszillatoranordnung mittels einer Übertragungstabelle, die in einem Speicher (ROM) (29) enthalten ist; und Übertragen des Divisors oder der digitalen Größe oder Information darüber auf die Steuerschleife (2), die **dadurch** den Oszillator (1) mittels eines Fehlersignals fein abstimmen kann, um das präzise Empfängersignal zu erzeugen, **dadurch gekennzeichnet, dass** der Divisor (N) oder die Information über diesen auf einen Frequenzteiler (31) übertragen wird, der in der Steuerschleife enthalten ist, in welchem die derzeitige Ausgangsfrequenz (7"') des Oszillators durch den Divisor geteilt wird, dass die geteilte Frequenz auf einen Phasendetektor (30) gesandt wird, der ähnlich in der Steuerschleife enthalten ist, und dass **das** Fehlersignal (F1) initiiert wird, welches die Frequenz (7) vom lokalen Oszillator so lange korrigiert, bis der Phasenfehler am Ausgang des Phasendetektors (30a) gleich Null ist oder einen kleinen Wert einnimmt.

2. Verfahren nach Anspruch 1, **dadurch gekennzeichnet, dass** die geschätzte Differenzfrequenz in digitaler Form an ein erstes digitales Addierwerk (23) zusammen mit der erforderlichen Frequenzdifferenz zwischen der lokalen Oszillatoranordnung und dem Übertragungsimpuls des Magnetrons (11), gesandt wird, und dass eine Differenz, die hier als Frequenzfehler (25) bezeichnet wird, zwischen der geschätzten Frequenz und der erforderlichen Frequenz initiiert wird.

3. Verfahren nach Anspruch 2, **dadurch gekennzeichnet, dass** in einem zweiten digitalen Addierwerk (27) entweder der Wert Null oder der Frequenzfehter addiert wird, was die Ausgangsfrequenz von der lokalen Oszillatoranordnung auf den geforderten Wert korrigiert,

4. Verfahren nach Anspruch 1, **dadurch gekennzeichnet, dass** eine Referenzfrequenz (32a) zum Phasendetektor gesandt wird.

5. Vorrichtung zum Erzeugen eines Empfängersignals (7'), das bezogen auf die Frequenz während einer bestimmten Abhörzeit präzise ist, in einem System mit einem Magnetron (10), das eine lokale Oszillatoranordnung (5) verwendet, in der ein spannungsgesteuerter Oszillator (VCO) durch eine Steuerschleife (2) gesteuert werden kann, wodurch eine erste Anordnung (17) angeordnet ist, um die Ausgangsfrequenz des Magnetrons und die Ausgangsfrequenz des Oszillators zu empfangen und zu vermischen (Multiplizieren) und um eine Differenzfrequenz in analoger Form zu erzeugen; einer zweiten Einrichtung (19), die nach der ersten Einrichtung angeordnet ist, die mit Funktionen zum Filtern, Digitalisieren und Abtasten versehen ist, um eine geschätzte Differenzfrequenz (22a') in digitaler Form zwischen den Ausgangsfrequenzen zu erzeugen; einer dritten Einrichtung (23), die zum Empfangen und Vergleichen der geschätzten Frequenz in digitaler Form mit einer geforderten Differenzfrequenz angeordnet ist, wobei das Vergleichsergebnis in einer vierten Einrichtung (27) für die Korrektur einer Frequenz verwendet wird, die durch eine Annäherungssetzfunktion (28) initiiert worden ist, wobei die Frequenz vor der Initiierung des Ausgangsimpulses des Magnetrons mittels der lokalen Oszillatoranordnung (5) annähernd gesetzt worden ist; wenigstens einem Speicher (ROM), der mit einer Übertragungstabelle mit Divisoren (N), vorzugsweise digitalen Größen, versehen ist, die in Relation zu unterschiedlich möglichen Ausgangsfrequenzen (7) von der lokalen Oszillatoranordnung gesetzt sind; wobei unter anderem unter Verwendung der derzeitigen Ausgangsfrequenz der lokalen Oszillatoranordnung ein relevanter Divisor oder eine relevante digitale Größe bestimmt werden kann; und wobei die Steuerschleife so angeordnet ist, dass sie den derzeitigen Divisor oder die digitale Größe oder die Information darüber empfängt und mittels eines Fehlersignals den Oszillator fein abstimmt, um das präzise Empfängersignal zu erzeugen, **dadurch gekennzeichnet, dass** die Steuerschleife einen Frequenzteiler (31) aufweist, der mit dem Ausgang des Oszillators verbunden ist und angeordnet ist, um den Divisor oder die digitale Größe oder die Information darüber zu empfangen und die derzeitige Frequenz (7"') des Oszillators durch den Divisor (N) zu teilen, und dass die Steuerschleife (2) einen Phasendetektor (30) aufweist, der für das Empfangen der geteilten Frequenz angeordnet ist und um unter Verwendung derselben das Fehlersignal (F1) zu erzeugen, das die Frequenz (7) vom lokalen Oszillator solange korrigiert, bis der Phasenfehler an dem Ausgang des Phasendetektors (30a) gleich Null ist oder einen kleinen Wert einnimmt.

6. Vorrichtung nach Anspruch 5, **dadurch gekennzeichnet, dass** ein erstes digitales Addierwerk (23) angeordnet ist, um die geschätzte Differenzfrequenz und die geforderte Frequenzdifferenz zwischen der Ausgangsfrequenz der lokalen Oszillatoranordnung und dem Übertragungsimpuls des Magnetrons zu empfangen und um die Differenz, hier als Frequenzfehler (25) bezeichnet, zwischen der geschätzten Frequenz und der geforderten Frequenz zu erzeugen.

7. Vorrichtung nach Anspruch 6, **dadurch gekennzeichnet, dass** ein zweites digitales Addierwerk (27) angeordnet ist, um entweder Null oder den Frequenzfehler zu addieren, was die Ausgangsfrequenz der lokalen Oszillatoranordnung auf den geforderten Wert korrigiert.

8. Vorrichtung nach Anspruch 5, 6 oder 7, **dadurch gekennzeichnet, dass** der Phasendetektor (30) vorgesehen ist, um eine Referenzfrequenz (32a) zu empfangen.

9. Vorrichtung nach einem der Ansprüche 5 bis 8, **dadurch gekennzeichnet, dass** die zweite Einrichtung (19) ein Tiefpassfilter (20) aufweist, das die Summierungsfrequenz in einem Mischer (17) abfiltert, der die erste Einrichtung bildet oder in der ersten Einrichtung enthalten ist.

10. Vorrichtung nach einem der Ansprüche 5 bis 9, **dadurch gekennzeichnet, dass** die zweite Einrichtung (19) einen Komparator (21) aufweist, der eine von einer Filterfunktion erzielte Signalfrequenz digitalisiert.

11. Vorrichtung nach einem der Ansprüche 7 bis 10, **dadurch gekennzeichnet, dass** die zweite Einrichtung eine digitale Schaltung, hier als Frequenzzähler (22) bezeichnet, aufweist, die die Frequenz des Signals von dem Komparator schätzt, wobei die digitale Schaltung angeordnet ist, um während des Übertragungsimpulses des Magnetrons, beispielsweise mit einer Dauer von 0,5 µs, Daten abzutasten und danach die Frequenz zu schätzen.

12. Vorrichtung nach Anspruch 11, **dadurch gekennzeichnet, dass** das erste digitale Addierwerk (23) mit den Ausgängen der digitalen Schaltung/dem Frequenzzähler (22) und einer Einheit (24) verbunden ist, die die geforderte Frequenzdifferenz zwischen dem Oszillator und dem Übertragungspuls des Magnetrons erzeugt, und dass das erste digitale Addierwerk mit dem zweiten digitalen Addierwerk über eine Umschaltfunktion (26) mit abgeschalteten und verbundenen Positionen, verbunden ist, wobei das zweite Addierwerk so lange abgeschaltet ist, bis die Frequenzschätzung bereit ist und verbunden ist, wenn Frequenzfehler zu erzeugen sind, die die Oszillatorfrequenz auf die geforderte Frequenz korrigieren.

13. Vorrichtung nach Anspruch 11 oder 12, **dadurch gekennzeichnet, dass** die Abtastzeit der digitalen Schaltung und der Umschaltschalter so angeordnet sind, dass sie von der System-Synchronisationsfunktion (15', 15") gesteuert werden können.

14. Vorrichtung nach Anspruch 10, **dadurch gekennzeichnet, dass** der Komparator (21), der eine von der Filterfunktion empfangene Signalfrequenz digitalisiert, zwei Ausgangspegel hat.

15. Vorrichtung nach Anspruch 10, **dadurch gekennzeichnet, dass** der Komparator (21), der eine von einer Filterfunktion empfangene Signalfrequenz digitalisiert, mehr als zwei Ausgangspegel hat.

16. Vorrichtung nach einem der Ansprüche 10, 14 oder 15, **dadurch gekennzeichnet, dass** der Komparator (21) einen A/D-Wandler aufweist.

## Revendications

1. Procédé pour produire un signal de récepteur (7') qui est précis en termes de fréquence pendant un temps d'écoute déterminé (Lt) dans un système comprenant un magnétron (10) utilisant un agencement d'oscillateur local (5), dans lequel un oscillateur commandé en tension (VCO) est commandé par une boucle de commande (2), moyennant quoi pendant l'impulsion de sortie du magnétron, le mélange (multiplication) de la fréquence de sortie du magnétron par la fréquence de sortie de l'oscillateur commandé en tension, de manière à créer une fréquence de différence (18) sous forme analogique, est effectué par un mélangeur (17) ; un filtrage (20), une numérisation (21) et un échantillonnage (22) dans ledit ordre pour générer une fréquence de différence estimée (22a') sous forme numérique entre lesdites fréquences de sortie, sont effectués après ledit mélange ; une comparaison entre la fréquence estimée (22a') sous forme numérique et une fréquence de différence requise, le résultat de la comparaison étant utilisé à des fins de correction d'une fréquence qui, avant le déclenchement de l'impulsion de sortie du magnétron, est réglée de manière approximative au moyen de l'agencement d'oscillateur local ; une production au moyen d'une table de conversion incluse dans une mémoire (ROM) (29) d'un diviseur, de préférence une quantité numérique, qui se rapporte à la valeur de la fréquence de sortie actuelle de l'agencement d'oscillateur local ; et la transmission du diviseur ou de la quantité numérique ou d'informations concernant cela à la boucle de commande (2), qui peut de ce fait accorder de manière fine l'oscillateur (1) au moyen d'un signal d'erreur pour fournir le signal de récepteur précis, **caractérisé en ce que** le diviseur (N) ou les informations le concernant sont transmis (es) à un diviseur de fréquence (31) compris dans la boucle de commande, dans lequel la fréquence de sortie actuelle de l'oscillateur (7"') est divisée par le diviseur, **en ce que** la fréquence divisée est envoyée à un détecteur de phase (30) qui est compris de manière similaire dans la boucle de commande, et est **en ce que** ledit signal d'erreur (F1) est déclenché pour corriger la fréquence (7) issue de l'oscillateur local jusqu'à ce que l'erreur de phase au niveau de la sortie du détecteur de phase (30a) soit égale à zéro ou présente une valeur faible.

2. Procédé selon la revendication 1, **caractérisé en ce que** la fréquence de différence estimée sous forme numérique est envoyée à un premier additionneur numérique (23) avec la différence de fréquence requise entre l'agencement d'oscillateur local et l'impulsion d'émission du magnétron (11), et **en ce qu'**une différence, appelée ici erreur de fréquence (25), entre la fréquence estimée et la fréquence requise est déclenchée.

3. Procédé selon la revendication 2, **caractérisé en ce que** dans un second additionneur numérique (27), est ajoutée la valeur zéro ou l'erreur de fréquence,
corrigeant la fréquence de sortie de l'agencement d'oscillateur local de manière à obtenir la valeur requise.

4. Procédé selon la revendication 1, **caractérisé en ce qu'**une fréquence de référence (32a) est envoyée au détecteur de phase.

5. Dispositif pour produire un signal de récepteur (7') qui est précis en termes de fréquence pendant un temps d'écoute déterminé dans un système comprenant un magnétron (10) utilisant un agencement d'oscillateur local (5), dans lequel un oscillateur commandé en tension (VCO) peut être commandé par une boucle de commande (2), moyennant quoi des premiers moyens (17) sont agencés pour recevoir et mélanger (multiplier) la fréquence de sortie du magnétron par la fréquence de sortie de l'oscillateur et pour créer une fréquence de différence sous forme analogique ; des deuxièmes moyens (19) agencés après les premiers moyens, sont agencés avec des fonctions de filtrage, de numérisation et d'échantillonnage de manière à générer une fréquence de différence estimée (22a') sous forme numérique entre lesdites fréquences de sortie ; des troisièmes moyens (23) sont agencés pour recevoir et comparer la fréquence estimée sous forme numérique à une fréquence de différence requise, le résultat de la comparaison étant utilisé dans des quatrièmes moyens (27) permettant de procéder à une correction d'une fréquence déclenchée par une fonction de réglage approximatif (28), laquelle fréquence, avant le déclenchement de l'impulsion de sortie du magnétron, est réglée de manière approximative au moyen de l'agencement d'oscillateur local (5) ; au moins une mémoire (ROM) est agencée avec une table de conversion avec des diviseurs (N), de préférence des quantités numériques, qui sont réglés par rapport à des fréquences de sortie possibles différentes (7) de l'agencement d'oscillateur local ; un diviseur approprié ou une quantité numérique peut être déterminé(e) entre autres en utilisant la fréquence de sortie actuelle de l'agencement d'oscillateur local ; et ladite boucle de commande est agencée pour recevoir le diviseur actuel ou la quantité numérique ou les informations les concernant, et pour accorder de manière fine l'oscillateur, au moyen d'un signal d'erreur, de manière à fournir le signal de récepteur précis, **caractérisé en ce que** la boucle de commande comprend un diviseur de fréquence (31) connecté à la sortie de l'oscillateur et agencé pour recevoir le diviseur ou la quantité numérique ou les informations les concernant et pour diviser la fréquence actuelle de l'oscillateur (7"') par le diviseur (N), et **en ce que** la boucle de commande (2) comprend un détecteur de phase (30) agencé pour recevoir la fréquence divisée et, en utilisant ceci, pour générer ledit signal d'erreur (F1) qui corrige la fréquence (7) de l'oscillateur local jusqu'à ce que l'erreur de phase au niveau de la sortie du détecteur de phase (30a) soit égale à zéro ou présente une valeur faible.

6. Dispositif selon la revendication 5, **caractérisé en ce qu'**un premier additionneur numérique (23) est agencé pour recevoir la fréquence de différence estimée et la différence de fréquence requise entre la fréquence de sortie de l'agencement d'oscillateur local et l'impulsion d'émission du magnétron, et pour générer une différence, appelée ici erreur de fréquence (25), entre la fréquence estimée et la fréquence requise.

7. Dispositif selon la revendication 6, **caractérisé en ce qu'**un second additionneur numérique (27) est agencé de manière à ajouter la valeur zéro ou l'erreur de fréquence, corrigeant la fréquence de sortie de l'agencement d'oscillateur local de manière à obtenir la valeur requise.

8. Dispositif selon la revendication 5, 6 ou 7, **caractérisé en ce que** le détecteur de phase (30) est agencé de manière à recevoir une fréquence de référence (32a).

9. Dispositif selon l'une quelconque des revendications 5 à 8, **caractérisé en ce que** les deuxièmes moyens (19) comprennent un filtre passe-bas (20) qui filtre la fréquence de somme provenant d'un mélangeur (17) constituant les premiers moyens ou compris dans les premiers moyens.

10. Dispositif selon l'une quelconque des revendications 5 à 9, **caractérisé en ce que** les deuxièmes moyens (19) comprennent un comparateur (21) qui numérise une fréquence de signal obtenue à partir d'une fonction de filtrage.

11. Dispositif selon l'une quelconque des revendications 7 à 10, **caractérisé en ce que** les deuxièmes moyens comprennent un circuit numérique, appelé ici compteur de fréquence (22), qui estime la fréquence du signal provenant du comparateur, lequel circuit numérique est agencé pour échantillonner des données pendant l'impulsion d'émission du magnétron, par exemple avec une durée de 0,5 µs, et pour estimer ensuite la fréquence.

12. Dispositif selon la revendication 11, **caractérisé en ce que** le premier additionneur numérique (23) est connecté aux sorties du circuit numérique/du compteur de fréquence (22) et à une unité (24) qui génère la différence de fréquence requise entre l'oscillateur et l'impulsion d'émission du magnétron, et **en ce que** le premier additionneur numérique est connecté au second additionneur numérique par l'intermédiaire d'une fonction de commutation (26) avec des positions déconnectée et connectée, le second additionneur étant déconnecté jusqu'à ce que l'estimation de fréquence soit prête, et étant connecté quand il doit générer des erreurs de fréquence qui corrigent la fréquence de l'oscillateur de manière à obtenir la fréquence requise.

13. Dispositif selon la revendication 11 ou 12,
**caractérisé en ce que** le temps d'échantillonnage du circuit numérique et le commutateur sont agencés de manière à pouvoir être commandés par la fonction de synchronisation du système (15', 15").

14. Dispositif selon la revendication 10, **caractérisé en ce que** le comparateur (21) qui numérise une fréquence de signal reçue en provenance de la fonction de filtrage comprend deux niveaux de sortie.

15. Dispositif selon la revendication 10, **caractérisé en ce que** le comparateur (21) qui numérise une fréquence de signal reçue en provenance de la fonction de filtrage comprend plus de deux niveaux de sortie.

16. Dispositif selon l'une quelconque des revendications 10, 14 ou 15, **caractérisé en ce que** le comparateur (21) comprend un convertisseur A/N.
